# EUROPEAN PATENT APPLICATION

(11) **EP 3 761 383 A1**
(43) Date of publication of application: **06.01.2021**
(21) Application number: 20183894.3
(22) Date of filing: 03.07.2020
(51) Int. Cl.: H01L 41/08, H01L 41/187, H01L 41/316, H01L 41/319, C04B 35/495, H01L 41/047, H03H 9/145

(54) **PIEZOELECTRIC LAMINATE, PIEZOELECTRIC ELEMENT AND METHOD OF MANUFACTURING THE PIEZOELECTRIC LAMINATE**

(30) Priority: 04.07.2019 JP 2019125165
(71) Applicant: SUMITOMO CHEMICAL COMPANY LIMITED, Chuo-ku Tokyo 104-8260 (JP)
(72) Inventor: SHIBATA, Kenji, Ibaraki, 3191418 (JP); WATANABE, Kazutoshi, Ibaraki, 3191418 (JP); KURODA, Toshiaki, Ibaraki, 3191418 (JP)
(74) Representative: Vossius & Partner Patentanwälte Rechtsanwälte mbB

(57) **Abstract**

There is provided a piezoelectric laminate (10), including: a substrate (1); a base layer (7) formed on the substrate (1); and a piezoelectric film (3) containing alkali niobium oxide and having a perovskite structure, which is formed on the base layer (7), as a polycrystalline film, and represented by a composition formula of (K₁₋ₓNaₓ)NbO₃ (0 < x < 1), wherein a crystal grain group forming the piezoelectric film (7) includes a crystal grain (8) having a ratio of 0.01 nm⁻¹ or more and 0.1 nm⁻¹ or less, which is the ratio of an outer peripheral length to a cross-sectional area when observing a cross-section of the crystal grain (8).

## Description

### TECHNICAL FIELD

The present disclosure relates to a piezoelectric laminate, a piezoelectric element, and a method of manufacturing a piezoelectric laminate.

### DESCRIPTION OF RELATED ART

A piezoelectric material is utilized widely for a functional electronic component such as a sensor, and an actuator. Lead-based materials, in particular, PZT-based ferroelectrics represented by a composition formula of Pb(Zr₁₋ₓTiₓ)O₃ are used widely for the piezoelectric material. Since PZT-based piezoelectric material contains lead, it is not preferable from a viewpoint of a pollution prevention, and the like. Therefore, potassium sodium niobate (KNN) is suggested as a piezoelectric material not containing lead (see patent documents 1 and 2, for example). Recently, it is strongly required to further improve a performance of the piezoelectric material configured by the material not containing lead such as KNN.

### PRIOR ART DOCUMENT

### PATENT DOCUMENT

Patent document 1: Japanese Patent Laid Open Publication No.2007-184513
Patent document 2: Japanese Patent Laid Open Publication No.2008-159807

### SUMMARY

### PROBLEM TO BE SOLVED BY DISCLOSURE

The present disclosure discloses a piezoelectric film containing alkali niobium oxide with longer lifetime.

According to an aspect of the present disclosure, there is provided a piezoelectric laminate, including:
a substrate;
a base layer formed on the substrate; and
a piezoelectric film containing alkali niobium oxide and having a perovskite structure, which is formed on the base layer, as a polycrystalline film, and represented by a composition formula of (K₁₋ₓNaₓ)NbO₃ (0 < x < 1),
wherein a crystal grain group forming the piezoelectric film includes a crystal grain having a ratio of 0.01 nm⁻¹ or more and 0.1 nm⁻¹ or less, which is the ratio of an outer peripheral length to a cross-sectional area when observing a cross-section of the crystal grain.

According to the present disclosure, there is provided the piezoelectric film containing alkali niobium oxide with longer lifetime.

### BRIEF DESCRIPTION OF THE DRAWINGS

FIG. 1 is a view illustrating an example of a cross-section structure of a piezoelectric laminate according to an embodiment of the present disclosure.
FIG. 2 is a view illustrating a modified example of the cross-section structure of the piezoelectric laminate according to an embodiment of the present disclosure.
FIG. 3 illustrates an example of a cross-section schematic view of a piezoelectric film according to an embodiment of the present disclosure.
FIG. 4 is a view illustrating an example of a schematic constitution of a piezoelectric device according to an embodiment of the present disclosure.
FIG. 5 is a view illustrating a modified example of the cross-section structure of the piezoelectric laminate according to an embodiment of the present disclosure.
FIG. 6 is a view illustrating a modified example of the schematic constitution of the piezoelectric device according to an embodiment of the present disclosure.

### EMBODIMENTS

### <An embodiment of the present disclosure>

An embodiment of the present disclosure will be described hereafter, with reference to drawings.

### (1) A constitution of a piezoelectric laminate

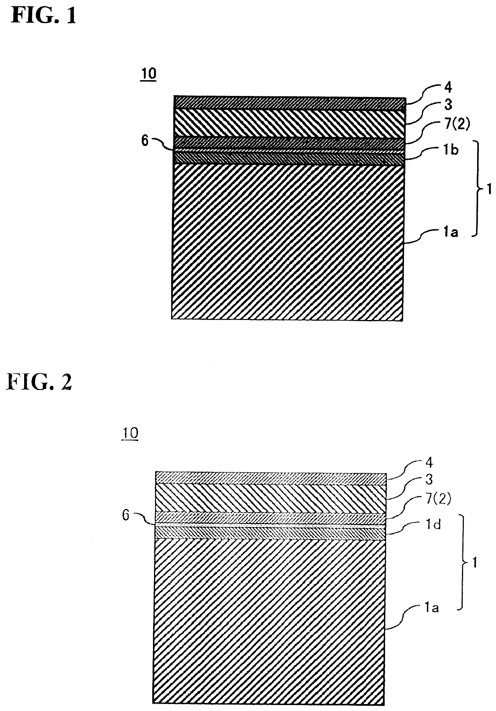

As illustrated in FIG. 1, a laminate (laminated substrate) 10 (also referred to as piezoelectric laminate 10 hereafter) having a piezoelectric film according to a present embodiment, includes a substrate 1, a base layer 7 formed on the substrate 1, a piezoelectric film (piezoelectric thin film) 3 formed on the base layer 7, and a top electrode film 4 formed on the piezoelectric film 3.

As the substrate 1, a single-crystal silicon (Si) substrate 1a on which a surface oxide film (SiO₂-film) 1b such as a thermal oxide film or a CVD (Chemical Vapor Deposition) oxide film is formed (provided), namely, a Si-substrate having the surface oxide film, can be used preferably. Further, as illustrated in FIG. 2, a Si-substrate 1a having an insulating film 1d formed on its surface may also be used as the substrate 1, the insulating film 1d containing an insulating material other than SiO2. Further, a Si-substrate 1 a in which Si-(100) plane or Si-(111) plane, etc., is exposed on a surface thereof, namely, a Si-substrate not having the surface oxide film 1b or the insulating film 1d may also be used as the substrate 1. Further, an SOI (Silicon On Insulator) substrate, a quartz glass (SiO₂) substrate, a gallium arsenide (GaAs) substrate, a sapphire (Al₂O₃) substrate, a metal substrate containing a metal material such as stainless steel (SUS) may also be used as the substrate 1. The single-crystal Si-substrate 1a has a thickness of, for example, 300 to 1000 µm, and the surface oxide film 1b has a thickness of, for example, 5 to 3000 nm.

The base layer 7 is a layer which is a base of the piezoelectric film 3. The base layer 7 also functions as a bottom electrode film 2. The bottom electrode film 2 can be formed (provided, deposited) using, for example, platinum (Pt). The bottom electrode film 2 is a polycrystalline film (this is also referred to as Pt-film hereafter). Preferably, crystals forming (included in) the Pt-film are preferentially oriented in (111) plane direction with respect to a surface of the substrate 1. Namely, a surface of the Pt-film (a surface which is a base of the piezoelectric film 3) is preferably mainly constituted of Pt-(111) plane. The Pt-film can be formed using a method such as a sputtering method, or an evaporation method. Instead of Pt, the bottom electrode film 2 may also be formed using various metals such as gold (Au), ruthenium (Ru), or iridium (Ir), an alloy mainly composed of the above various metals, or a metallic oxide such as strontium ruthenate (SrRuO₃, abbreviated as SRO), lanthanum nickel oxide (LaNiO₃, abbreviated as LNO), or strontium titanate (SrTiO₃, abbreviated as STO), etc. An adhesion layer 6 mainly composed of, for example, titanium (Ti), tantalum (Ta), titanium oxide (TiO₂), nickel (Ni), ruthenium oxide (RuO₂), or iridium oxide (IrO₂), etc., may be formed between the substrate 1 and the bottom electrode film 2 in order to enhance an adhesion between them. The adhesion layer 6 can be formed using a method such as a sputtering method, or an evaporation method. The bottom electrode film 2 has a thickness of, for example, 100 to 400 nm, and the adhesion layer 6 has a thickness of, for example, 1 to 200 nm.

The piezoelectric film 3 can be formed (provided, deposited) using alkali niobium oxide which contains, for example, potassium (K), sodium (Na), and niobium (Nb), and which is represented by a composition formula of (K₁₋ₓNaₓ)NbO₃. Namely, the piezoelectric film 3 can be formed using potassium sodium niobate (KNN). A coefficient x [= Na/(K+Na)] in the above composition formula is a value in a range of 0 < x < 1. The piezoelectric film 3 is a polycrystalline film of KNN (also referred to as KNN-film 3 hereafter). A crystal structure of KNN is a perovskite structure. The KNN-film 3 can be formed using a method such as a sputtering method, a PLD (Pulsed Laser Deposition) method, or a sol-gel method. The KNN-film 3 has a thickness of, for example, 0.5 to 5 µm.

Preferably, crystals forming (included in) the KNN-film 3 are preferentially oriented in (001) plane direction with respect to the surface of the substrate 1 (the surface of the Si-substrate 1a when the substrate 1 is, for example, the Si-substratc 1a having the surface oxide film 1b or the insulating film 1d, etc.). Namely, a surface of the KNN-film 3 (a surface which is a base of the top electrode film 4) is preferably mainly constituted of KNN-(001) plane. By forming the KNN-film 3 directly on the Pt-film preferentially oriented in (111) plane direction with respect to the surface of the substrate 1, crystals included in the KNN-film 3 can be easily preferentially oriented in (001) plane direction with respect to the surface of the substrate 1. For example, 80 % or more crystals included in a crystal grain group forming the KNN-film 3 (crystals included in the crystal grain group in the KNN-film 3) can be easily oriented in (001) plane direction with respect to the surface of the substrate 1, and 80 % or more regions of the surface of the KNN-film 3 can be easily KNN-(001) plane.

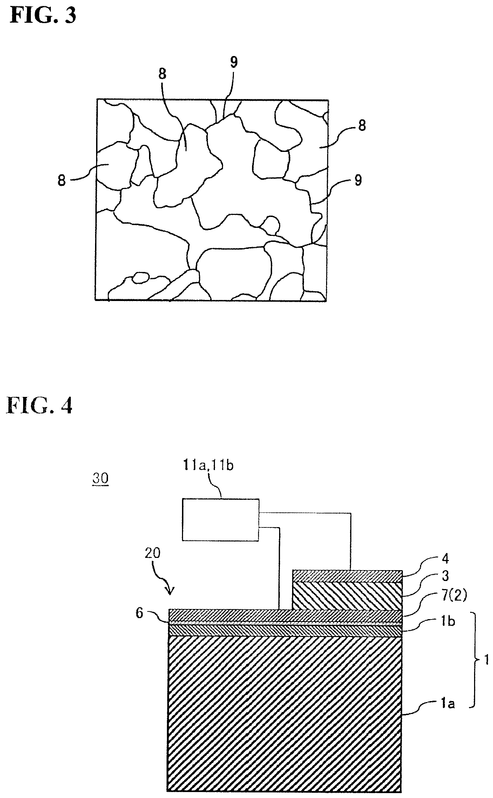

More than half of the crystals included in the crystal grain group in the KNN-film 3 preferably have a columnar structure. Boundaries between the crystals included in the KNN-film 3, namely crystal grain boundaries 9 (see FIG. 3 for example) existing in the KNN-film 3 preferably penetrate the KNN-film 3 in a thickness direction. For example, the number of the crystal grain boundaries 9 penetrating the KNN-film 3 in the thickness direction is larger than the number of the crystal grain boundaries not penetrating the KNN-film 3 in the thickness direction (for example, crystal grain boundaries in parallel to a planar direction of the substrate 1).

As illustrated in FIG. 3, the crystal grain group in the KNN-film 3 includes a crystal grain 8 having a smooth side surface with less unevenness (a crystal grain 8 having a smooth contour in a cross-section, and also referred to as "smooth crystal grain 8" hereafter). For example, the crystal grain group in the KNN-film 3 includes the crystal grain 8 having a ratio (= B/A-ratio) of 0.01 nm⁻¹ or more and 0.1 nm⁻¹ or less, preferably 0.02 nm⁻¹ or more and 0.08 nm⁻¹ or less, and more preferably 0.02 nm^{-l} or more and 0.06 nm⁻¹ or less, which is the ratio of an outer peripheral length B (nm) to a cross-sectional area A (nm²) when observing a cross-section of the crystal grain 8. The crystal grain 8 having a smaller B/A-ratio value is the crystal grain 8 having the smooth side surface with less unevenness. The term "cross-section" used in the present specification means a section of the crystal grain 8 in the planar direction of the substrate 1, namely, an in-plane direction of the substrate 1. The B/A-ratio can be calculated by analyzing an image such as a scanning electron microscopy (SEM) image, a transmission electron microscopy (TEM) image, or a scanning transmission electron microscopy (STEM) image of the cross-section of the KNN-film 3.

By including the smooth crystal grain 8 in the crystal grain group in the KNN-film 3, the crystal grain boundaries 9 penetrating the KNN-film 3 in the thickness direction have a smooth shape. Namely, the crystal grain boundaries 9 have a smooth shape when observing the cross-section of the KNN-film 3. As a result, the crystal grain boundaries 9 existing in the KNN-film 3 can be reduced. Namely, a grain boundary density in the KNN-film 3 can be lowered. The term "grain boundary density" used in the present specification means a ratio of a total length of the crystal grain boundaries 9 existing in the cross-section of the KNN-film 3 to a cross-sectional area of the KNN-film 3 when observing the cross-section of the KNN-film 3 (the ratio = the total length of the crystal grain boundaries 9 of the crystal grains 8 / the cross-sectional area of the KNN-film 3).

Oxygen vacancies (Oxygen deficiencies) exist at a predetermined ratio inside the crystal grains 8 (crystals) included in the KNN-film 3 or on the side surfaces of the crystal grains 8 (namely, the crystal grain boundaries 9 between the crystals). Of these oxygen vacancies, particularly the oxygen vacancies existing on the crystal grain boundaries 9 in the KNN-film 3, sometimes move when applying an electric field to a piezoelectric element 20 (piezoelectric device 30) described later produced by processing the piezoelectric laminate 10. When the oxygen vacancies move and reach the electrode film (the bottom electrode film 2 or the top electrode film 4), the oxygen vacancies react with the metal in the electrode film, resulting in causing short-circuit. By including the smooth crystal grains 8 in the KNN-film 3 and lowering the grain boundary density, an amount (an absolute amount) of the oxygen vacancies existing on the crystal grain boundaries 9 in the KNN-film 3 can be reduced. For example, a ratio can be reduced, which is the ratio of the oxygen vacancies existing on the crystal grain boundaries 9 in the KNN-film 3 to the oxygen vacancies (a total oxygen vacancies in the KNN-film 3) existing inside the crystals included in the KNN-film 3 and on the crystal grain boundaries 9 (the ratio = the oxygen vacancies existing on the crystal grain boundaries 9 / the total oxygen vacancies).

When the crystal grain 8 included in the KNN-film 3 (crystal grain group in the KNN-film 3) has almost the same average grain size (also referred to as " average crystal grain size" hereafter), the higher the ratio of the crystal grains 8 having the above B/A-ratio, the lower the grain boundary density in the KNN-film 3. From a viewpoint of lowering the grain boundary density in the KNN-film 3, the crystal grain group in the KNN-film 3 preferably includes the crystal grains 8 having the above B/A-ratio as many as possible.

Preferably, for example, an average value of the B/A-ratio (also referred to as "average B/A-ratio" hereafter) of the crystal grain group in the KNN-film 3 is 0.01 nm⁻¹ or more and 0.1 nm⁻¹ or less, preferably 0.02 nm⁻¹ or more and 0.08 nm⁻¹ or less, and more preferably 0.02 nm⁻¹ or more and 0.06 nm⁻¹ or less. The term "average value of the B/A-ratio" means an average of the values excluding large deviations from the above B/A-ratios of all crystal grains 8 existing in the cross-section, when observing the cross-section of the KNN-film 3. The smaller the average B/A-ratio, the smoother the crystal grain boundaries 9 are in the entire surface of the KNN-film 3.

Further, for example, 60 % or more, and preferably 80 % or more crystal grains 8 included in the crystal grain group in the KNN-film 3 preferably have the above B/A-ratio. Thereby, the crystal grain boundaries 9 can reliably have a smooth shape over the entire surface of the KNN-film 3. Furthermore, all crystals included in the crystal grain group in the KNN-film 3 further preferably have the above B/A-ratio. Thereby, the crystal grain boundaries 9 can further reliably have a smooth shape over the entire surface of the KNN-film 3.

The average crystal grain size in the KNN-film 3 is preferably, for example, 100 nm or more. The average crystal grain size in the KNN-film 3 used herein is an average crystal grain size in the cross-section of the KNN-film 3 in the planar direction of the substrate 1. The average crystal grain size in the KNN-film 3 can be obtained by analyzing a visual field of an image (for example, SEM image) imaged using a scanning electron microscopy or an image (for example, TEM image) imaged using a transmission electron microscopy. For example, "Image J" manufactured by Wayne Rasband can be used as an image analysis software.

When the crystal grain 8 has almost the same average B/A-ratio when observing the cross-section of the KNN-film 3, the larger the average crystal grain size, the lower the grain boundary density in the KNN-film 3. Therefore, by increasing the average crystal grain size in the KNN-film 3, the grain boundary density in the KNN-film 3 can be further lowered.

From a viewpoint of lowering the grain boundary density in the KNN-film 3, the larger average crystal grain size in the KNN-film 3 is preferable. However, when the average crystal grain size in the KNN-film 3 is larger than the thickness of the KNN-film 3, an in-plane uniformity of a piezoelectric property is sometimes deteriorated. Therefore, from a viewpoint of suppressing the deterioration of the in-plane uniformity which is the piezoelectric property, the average crystal grain size in the KNN-film 3 is preferably smaller than the thickness of the KNN-film 3.

The KNN-film 3 preferably contains at least one of metallic elements selected from a group consisting of copper (Cu) and manganese (Mn) at a concentration in a range of, for example, 0.2 at% or more and 2.0 at% or less. When the KNN-film 3 contains the metallic elements of Cu and Mn, a total concentration of Cu and Mn is preferably in the above range.

By containing Cu or Mn in the KNN-film 3 at the concentration of 0.2 at% or more, an insulation property (a leakage resistance) of the KNN-film 3 can be improved. Further, by containing Cu in the KNN-film 3 at the concentration of 0.2 at% or more, a resistance to a fluorine-based etching solution (etching resistance) can be improved. Further, by containing Cu or Mn in the KNN-film 3 at the concentration of 2.0 at% or less, a dielectric constant of the KNN-film 3 can be a value suitable for applications such as a sensor, and an actuator, etc. For example, the dielectric constant of the KNN-film 3 when being measured under a condition of a frequency of 1 kHz, ± 1 V, can be 1000 or less (300 or more and 1000 or less).

The KNN-film 3 may contain an element such as lithium (Li), Ta, antimony (Sb) other than K, Na, Nb, Cu, and Mn in a range of not impairing the above effect of lowering the grain boundary density in the KNN-film 3, for example, in a range of 5 at% or less (when adding a plurality of the above elements, a total concentration is 5 at% or less).

The top electrode film 4 can be formed (provided, deposited) using various metals such as, for example, Pt, Au, aluminum (Al), or Cu, or an alloy of these various metals. The top electrode film 4 can be formed using a method such as a sputtering method, an evaporation method, a plating method, or a metal paste method. The top electrode film 4 does not greatly affect the crystal structure of the KNN-film 3 unlike the bottom electrode film 2. Therefore, a material and a crystal structure of the top electrode film 4, and a method of forming the top electrode film 4 are not particularly limited. An adhesion layer mainly composed of, for example, Ti, Ta, TiO₂, Ni, RuO₂, or IrO₂, etc., may be formed between the KNN-film 3 and the top electrode film 4 in order to enhance an adhesion between them. The top electrode film 4 has a thickness of, for example, 10 to 5000 nm, and the adhesion layer has a thickness of, for example, 1 to 200 nm when forming the adhesion layer.

### (2) A constitution of a piezoelectric device

FIG. 4 illustrates a schematic constitution view of a device 30 (also referred to as piezoelectric device 30 hereafter) having the KNN-film 3 of the present embodiment. The piezoelectric device 30 includes at least an element 20 (an element 20 having the KNN-film 3, also referred to as piezoelectric element 20 hereafter) obtained by forming the above piezoelectric laminate 10 into a prescribed shape, and a voltage application unit 11a or a voltage detection unit 11b connected to the piezoelectric element 20. The voltage application unit 11a is a means for applying a voltage between the bottom electrode film 2 and the top electrode film 4 (between electrodes), and the voltage detection unit 11b is a means for detecting a voltage generated between the bottom electrode film 2 and the top electrode film 4 (between electrodes). Publicly-known various means can be used as the voltage application unit 11a and the voltage detection unit 11b.

By connecting the voltage application unit 11a between the bottom electrode film 2 and the top electrode film 4 of the piezoelectric element 20, the piezoelectric device 30 can function as an actuator. By applying a voltage between the bottom electrode film 2 and the top electrode film 4 using the voltage application unit 11a, the KNN-film 3 can be deformed. Various members connected to the piezoelectric device 30 can be actuated due to the above deformation motion. In this case, the piezoelectric device 30 can be applied to, for example, a head for an inkjet printer, a MEMS mirror for a scanner, and a vibrator for an ultrasonic generator, etc.

By connecting the voltage detection unit 11b between the bottom electrode film 2 and the top electrode film 4 of the piezoelectric element 20, the piezoelectric device 30 can function as a sensor. When the KNN-film 3 is deformed according to a variation of some physical quantity, a voltage is generated between the bottom electrode film 2 and the top electrode film 4 due to the deformation. By detecting this voltage using the voltage detection unit 11b, the physical quantity applied to the KNN-film 3 can be measured. In this case, the piezoelectric device 30 can be applied to, for example, an angular velocity sensor, an ultrasonic sensor, a pressure sensor, and an acceleration sensor, etc.

### (3) A method of manufacturing a piezoelectric laminate, a piezoelectric element, and a piezoelectric device

A method of manufacturing the above piezoelectric laminate 10, the piezoelectric element 20, and the piezoelectric device 30 will be described hereafter.

First, the substrate 1 is prepared, and the adhesion layer 6 (Ti-layer) and the base layer 7, namely, the bottom electrode film 2 (Pt-film) are formed in this order on any one of main surfaces of the substrate 1 using, for example, the sputtering method. It is also acceptable to prepare the substrate 1 on which the adhesion layer 6 and the base layer 7 (the bottom electrode film 2) are formed in advance on any one of its main surfaces.

For example, the following conditions are given as the conditions for forming the adhesion layer 6.
Temperature (substrate temperature): 100 °C or more and 500 °C or less, preferably 200 °C or more and 400 °C or less
RF power: 1000 W or more and 1500 W or less, preferably 1100 W or more and 1300 W or less
Atmosphere: Argon (Ar) gas atmosphere
Atmosphere pressure: 0.1 Pa or more and 0.5 Pa or less, preferably 0.2 Pa or more and 0.4 Pa or less
Processing time: 30 seconds or more and 3 minutes or less, preferably 45 seconds or more and 2 minutes or less

For example, the following conditions are given as the conditions for forming the base layer 7, namely, the bottom electrode film 2.
Deposition temperature (substrate temperature): 600 °C or more and 800 °C or less, preferably 600 °C or more and 700 °C or less
RF power: 1000 W or more and 1500 W or less, preferably 1100 W or more and 1300 W or less
Deposition atmosphere: Ar-gas atmosphere
Atmosphere pressure: 0.1 Pa or more and 0.5 Pa or less, preferably 0.2 Pa or more and 0.3 Pa or less
Deposition time: 3 minutes or more and 10 minutes or less, preferably 3 minutes or more and 7 minutes or less

By forming the bottom electrode film 2 under the above conditions, namely, by setting the deposition temperature of the bottom electrode film 2 to high (for example, 600 °C or more), the bottom electrode film 2 including Pt-particles having smooth side surfaces with less unevenness can be formed. For example, grain boundaries, which are boundaries between adjacent Pt-particles, can have a smooth shape when observing a cross-section of the bottom electrode film 2. Further, by setting the deposition temperature of the bottom electrode film 2 to high, particle sizes of the Pt-particles can also be increased. Even by setting the deposition temperature of the bottom electrode film 2 to more than 800 °C, there are limits in the effect of making the grain boundaries of the Pt particles have a smooth shape and the effect of increasing the particle size of the Pt-particles, and in addition, a thermal history of the bottom electrode film 2 increases. Therefore, the deposition temperature of the bottom electrode film 2 is preferably set to 800 °C or less.

Next, the KNN-film 3 is formed on the base layer 7, namely, the bottom electrode film 2. The KNN-film 3 is grown while having structures of the Pt-particles included in the surface of the bottom electrode film 2 (the surface which is a base of the KNN-film 3). Therefore, by forming the KNN-film 3 on the bottom electrode film 2 formed under the above conditions, the crystal grains 8 included in the KNN-film 3 can be smooth crystal grains. Namely, the KNN-film 3 including the crystal grains 8 having the B/A-ratio of 0.01 nm⁻¹ or more and 0.1 nm⁻¹ or less, can be formed. Preferably, the KNN-film 3 including the crystal grains 8 having the average B/A-ratio of 0.01 nm⁻¹ or more and 0.1 nm⁻¹ or less, can be formed. Further, the grain sizes of the crystal grains 8 included in the KNN-film 3 depend on the particle sizes of the Pt-particles of the bottom electrode film 2. Therefore, by forming the KNN-film 3 on the bottom electrode film 2 formed under the above conditions, the average crystal grain size in the KNN-film 3 can also be increased.

When the KNN-film 3 is formed using, for example, the sputtering method, a composition ratio of the KNN-film 3 can be adjusted by controlling, for example, a composition of a target material used during sputtering. The target material can be produced by mixing and baking K₂CO₃-powder, Na₂CO₃-powder, Nb₂O₅-powder, Cu-powder (or CuO-powder, Cu₂O-powder), or Mn-powder (MnO-powder), etc. The composition of the target material can be controlled by adjusting a mixed ratio of K₂CO₃-powder, Na₂CO₃-powder, Nb₂O₅-powder, Cu-powder, and Mn-powder, etc.

For example, the following conditions are given as the conditions for forming the KNN-film 3. A deposition time is appropriately set in accordance with the thickness of the KNN-film 3 to be formed.
Substrate temperature: 500 °C or more and 700 °C or less, preferably 550 °C or more and 650 °C or less
RF power: 2000 W or more and 2400 W or less, preferably 2100 W or more and 2300 W or less
Deposition atmosphere: Ar-gas + oxygen (O₂) gas atmosphere
Atmosphere pressure: 0.2 Pa or more and 0.5 Pa or less, preferably 0.3 Pa or more and 0.4 Pa or less
Partial pressure of Ar-gas to O₂-gas (partial pressure ratio of Ar/O₂): 30/1 to 20/1, preferably 27/1 to 22/1
Deposition rate: 0.5 µm/hr or more and 2 µm/hr or less, preferably 0.5 µm/hr or more and 1.5 µm/hr or less

Then, the top electrode film 4 is formed on the KNN-film 3 using, for example, the sputtering method. Conditions for forming the top electrode film 4 can be similar conditions as the above conditions for forming the bottom electrode film 2. Thereby, the piezoelectric laminate 10 having the substrate 1, the bottom electrode film 2, the KNN-film 3, and the top electrode film 4 can be obtained, for example, as illustrated in FIG. 1.

Then, by forming this piezoelectric laminate 10 into a prescribed shape using an etching, etc., the piezoelectric element 20 is obtained as illustrated in FIG. 4, and by connecting the voltage application unit 11a or the voltage detection unit 11b to the piezoelectric element 20, the piezoelectric device 30 is obtained.

### (4) Effect obtained by the present embodiment

According to the present embodiment, one or more of the following effects can be obtained.
(a) By including the crystal grain 8 having the B/A-ratio of 0.01 nm⁻¹ or more and 0.1 nm⁻¹ or less in the crystal grain group in the KNN-film 3, the crystal boundary density in the KNN-film 3 can be lowered. Thereby, the absolute amount of the oxygen vacancies existing on the crystal grain boundaries 9 in the KNN-film 3 can be reduced. Therefore, the oxygen vacancies that move when applying the electric field to the piezoelectric element 20 (piezoelectric device 30) produced by processing the piezoelectric laminate 10, can be reduced. As a result, the oxygen vacancies that reach the electrode film (the bottom electrode film 2 or the top electrode film 4) can be reduced, and the KNN-film 3 with longer lifetime can be obtain.
   For example, when Highly Accelerated Life Test (abbreviated as HALT) is performed, the KNN-film 3 that requires 18000 seconds or more before dielectric breakdown, can be obtained. HALT is performed under the following conditions. First, a positive or a negative electric field of 300 kV/cm is applied to the top electrode film 4, in a state where the piezoelectric laminate 10 including the KNN-film 3 is heated to a temperature of 200 °C. Then, time (seconds) from the start of applying the electric field until dielectric breakdown of the KNN-film 3 is measured, the electric field being at least one of the above electric fields (positive or negative electric field) applied under the above conditions. It is considered that the KNN-film 3 has caused dielectric breakdown, when a leakage current density flowing through the KNN-film 3 exceeds 30 mA/cm².
(b) Since the average B/A-ratio of the crystal grain group in the KNN-film 3 is, for example, 0.01 nm⁻¹ or more and 0.1 nm⁻¹ or less, the grain boundary density in the KNN-film 3 can be reliably lowered. Thereby, the KNN-film 3 with longer lifetime can be reliably obtained. For example, when HALT is performed under the above conditions, the KNN-film 3 that requires 18000 seconds or more before dielectric breakdown, can be reliably obtained. Further, according to the present disclosure, when the above HALT is performed, the KNN-film 3 that requires 25200 seconds or more, furthermore 30000 seconds or more before dielectric breakdown, can also be obtained.
   The present inventors performed HALT under the above conditions, for each of samples 1 to 8 of the KNN-film 3 having the average B/A-ratio of 0.01 nm⁻¹ or more and 0.1 nm⁻¹ or less. Each of the samples 1 to 8 was prepared under the condition such that the deposition temperature of the bottom electrode film 2 was 600 °C, and the other conditions were the same within the above range described in the above embodiment. Measurement results obtained by HALT are as follows: sample 1: 18990 seconds, sample 2: 21240 seconds, sample 3: 25200 seconds, sample 4: 37646 seconds, sample 5: 21888 seconds, sample 6: 18206 seconds, sample 7: 34251 seconds, and sample 8: 29376 seconds. The value obtained by HALT is an average value measured at 5 to 7 locations within 0.5 mm φ per 1 sample.
   Further, the present inventors performed HALT under the above conditions, for each of samples 9 to 12 of the KNN-film 3 having the average B/A-ratio not in the range of 0.01 nm⁻¹ or more and 0.1 nm⁻¹ or less. Each of the samples 9 to 12 was prepared under the condition such that the deposition temperature of the bottom electrode film 2 was 500 °C, and the other conditions were the same within the above range described in the above embodiment. Measurement results obtained by HALT are as follows: sample 9: 24891 seconds, sample 10: 16457 seconds, sample 11: 25080 seconds, sample 12: 24737 seconds. The value obtained by HALT is an average value measured at 3 to 7 locations within 0.5 mm φ per 1 sample. As described above, the present inventors have already confirmed that in a case of the KNN-film having the average B/A-ratio not in the range of 0.01 nm⁻¹ or more and 0.1 nm⁻¹ or less, the time until dielectric breakdown of the KNN-film is sometimes less than 18000 seconds, when performing HALT under the above conditions. Further, the present inventors have continued that in the case of the KNN-film having the average B/A-ratio not in the range of 0.01 nm⁻¹ or more and 0.1 nm⁻¹ or less, the KNN-film that requires 25200 seconds or more before dielectric breakdown, cannot be obtained.
(c) Since 60 % or more crystal grains 8 included in the crystal grain group in the KNN-film 3 have the above B/A-ratio, the grain boundary density in the KNN-film 3 can be more lowered. Thereby, the amount of the oxygen vacancies existing on the crystal grain boundaries 9 in the KNN-film 3 can be more reduced. As a result, when HALT is performed under the above conditions, the KNN-film 3 that requires 18000 seconds or more before dielectric breakdown, can be reliably obtained. Further, 80 % or more crystal grains 8 included in the crystal grain group in the KNN-film 3 have the above B/A-ratio, the grain boundary density in the KNN-film 3 can be further lowered. Thereby, the amount of the oxygen vacancies existing on the crystal grain boundaries 9 in the KNN-film 3 can be further reduced. As a result, when HALT is performed under the above conditions, the KNN-film 3 that requires 18000 seconds or more before dielectric breakdown, can be reliably obtained.
(d) Since the average crystal grain size in the KNN-film 3 is larger, for example, 100 nm or more, than an average crystal grain size in a conventional KNN-film, the grain boundary density in the KNN-film 3 can be reliably lowered. Thereby, in the KNN-film 3, the oxygen vacancies that move when applying the electric field, can be reduced. As a result, the oxygen vacancies that reach the electrode film when applying the electric field to the piezoelectric device 30, can be reliably reduced. Therefore, when HALT is performed under the above conditions, the KNN-film 3 that requires 18000 seconds or more before dielectric breakdown can be further reliably obtained.
(e) By including the crystal grain 8 having the above B/A-ratio in the KNN-film 3, the grain boundary density in the KNN-film 3 can be lowered, and the absolute value of the oxygen vacancies existing on the crystal grain boundaries 9 in the KNN-film 3 can be reduced, even when the average crystal grain size in the KNN-film 3 is less than 100 nm. Namely, even when the average crystal grain size in the KNN-film 3 is less than 100 nm, at least the above effect (a) can be obtained. Thus, by including the crystal grain 8 having the above B/A-ratio in the crystal grain group in the KNN-film 3, the KNN-film 3 with longer lifetime can be obtained even when the average crystal grain size in the KNN-film 3 is not large. Since the crystal grains 8 included in the KNN-film 3 are smooth, and the average crystal grain size in the KNN-film 3 is large (for example, the average crystal grain size is 100 nm or more), the KNN-film 3 that requires 18000 seconds or more before dielectric breakdown can be further reliably obtained, when HALT is performed under the above conditions.
(f) By containing Cu, for example, at the concentration of 0.2 at% or more and 2.0 at% or less in the KNN-film 3, the dielectric constant of the KNN-film 3 can be a value suitable for applications such as a sensor, or an actuator, etc., while obtaining the effect on an insulation property and the effect on an etching resistance of the KNN-film 3.

### (5) Modified examples

The present embodiment is not limited to the abovementioned embodiment, and can be modified as the following modified examples. Further, these modified examples can be arbitrarily combined.

### (Modified example 1)

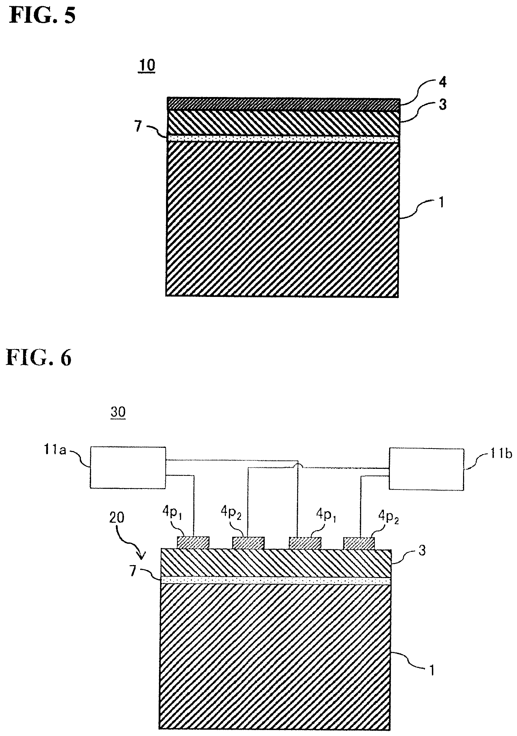

The base layer 7 does not function as the electrode film. As illustrated in FIG. 5 for example, the piezoelectric laminate 10 according to the present modified example is constituted including the substrate 1, the base layer 7 formed on the substrate 1, the KNN-film (piezoelectric film) 3 formed on the base layer 7, and the top electrode film 4 (electrode film 4) formed on the KNN-film 3. The base layer 7 of the present modified example has a thickness of, for example, 0.5 to 400 nm. Other constitutions are similar as those described in the above embodiment.

FIG. 6 illustrates the schematic constitution view of the piezoelectric device 30 produced using the piezoelectric laminate 10 according to the present modified example. The piezoelectric device 30 is constituted including at least the piezoelectric element 20 obtained by forming the piezoelectric laminate 10 into a prescribed shape, and the voltage application unit 11a and the voltage detection unit 11b connected to the piezoelectric element 20. In the present modified example, the piezoelectric element 20 has a pattern electrode obtained by forming the electrode film 4 into a prescribed pattern. For example, the piezoelectric element 20 has a pair of positive and negative pattern electrodes 4p₁ which are input-side electrodes, and a pair of positive and negative pattern electrodes 4p₂ which are output-side electrodes. For example, a comb-shaped electrode (Inter Digital Transducer, abbreviated as IDT) is used as the pattern electrodes 4p₁ and 4p₂.

By connecting the voltage application unit 11a between the pattern electrodes 4p₁ and connecting the voltage detection unit 11b between the pattern electrodes 4p₂, the piezoelectric device 30 can function as a filter device such as a Surface Acoustic Wave (abbreviated as SAW) filter. By applying the voltage between the pattern electrodes 4p₁ using the voltage application unit 11a, SAW can excite on the surface of the KNN-film 3. A frequency of excited SAW can be adjusted by adjusting, for example, a pitch between the pattern electrodes 4p₁. For example, the shorter the pitch of IDT as the pattern electrodes 4pi, the higher the frequency of SAW, and the longer the above pitch, the lower the frequency of SAW. The voltage is generated between the pattern electrodes 4p₂, due to SAW having a prescribed frequency (frequency component) determined according to the pitch of IDT as the pattern electrodes 4p₂ in SAW which is excited by the voltage application unit 11a, propagates in the KNN-film 3, and reaches the pattern electrodes 4p2. By detecting this voltage using the voltage detection unit 11b, SAW having a prescribed frequency in the excited SAW can be extracted. The "prescribed frequency" as used here can include not only a prescribed frequency but also a prescribed frequency band whose center frequency is prescribed frequency.

In the present modified example as well, by setting the temperature when forming the base layer 7 to high, particles forming the base layer 7 (particles included in the base layer 7) include a particle having a smooth side surface with less unevenness. Further, by setting the temperature when forming the base layer 7 to high, the particle sizes of the particles included in the base layer 7 can also be increased. As a result, the crystal grains 8 included in the KNN-film 3 can be smooth crystal grains. Namely, the crystal grain group in the KNN-film 3 includes the crystal grain 8 having the B/A-ratio of 0.01 nm⁻¹ or more and 0.1 nm⁻¹ or less. Preferably, the average B/A-ratio of the crystal grain group in the KNN-film 3 is 0.01 nm⁻¹ or more and 0.1 nm⁻¹ or less. Further, the average crystal grain size in the KNN-film 3 can also be increased. Namely, in the present modified example as well, similar effects as the above embodiment can be obtained.

### (Modified example 2)

An orientation control layer may be formed (provided, deposited) for controlling orientations of crystals included in the KNN-film 3 between the bottom electrode film 2 and the KNN-film 3, namely, directly under the KNN-film 3. In a case of the above modified example 1, the orientation control layer may be formed between the substrate 1 and the KNN-film 3. The orientation control layer can be formed using a material which is a metallic oxide such as SRO, LNO, or strontium titanate (SrTiO₃, abbreviated as STO), and which is different from the material included in the bottom electrode film 2. Preferably, crystals included in the orientation control layer are preferentially oriented in (100) plane direction with respect to the surface of the substrate 1.

### (Modified example 3)

In addition to Cu or Mn, or instead of Cu or Mn, the KNN-film 3 may contain other metallic elements obtained an effect equivalent to Cu or Mn at a concentration where the dielectric constant of the KNN-film 3 can be appropriate value, while obtaining the above effect of lowering the grain boundary density in the KNN-film 3. In this case as well, similar effects as the above embodiment and modified examples can be obtained.

### (Modified example 4)

After forming the KNN-film 3, a heat-treatment (high temperature-annealing) may be performed to the KNN-film 3. This heat-treatment may be performed before forming the top electrode film 4, or may be performed after forming the top electrode film 4. Thereby, the oxygen vacancies and impurities (carbon (C), hydrogen (H), etc.,) in the KNN-film 3 can be reduced.

For example, the following conditions are given as the conditions for the heat-treatment.
Annealing temperature: 600 °C or more and 800 °C or less, preferably 600 °C or more and 700 °C or less
Annealing time: 0.5 to 12 hours, preferably 1 to 6 hours, more preferably 2 to 3 hours
Annealing atmosphere: room air or oxygen-containing atmosphere

### (Modified example 5)

The substrate 1 may be removed from the piezoelectric laminate 10 when forming the above piezoelectric laminate 10 into the piezoelectric element 20, as long as the piezoelectric device 30 produced using the piezoelectric laminate 10 (piezoelectric element 20) is applied to desired applications such as a sensor or an actuator.

### <Other embodiment>

As described above, explanation has been given specifically for the embodiments of the present disclosure. However, the present disclosure is not limited to the above embodiment or the above modified examples, and can be variously modified in a range not departing from the gist of the disclosure.

<Preferable aspects of the present disclosure>

Preferable aspects of the present disclosure will be supplementarily described hereafter.

### (Supplementary description 1)

According to an aspect of the present disclosure, there is provided a piezoelectric laminate, including:
a substrate;
a base layer formed on the substrate; and
a piezoelectric film containing alkali niobium oxide and having a perovskite structure, which is formed on the base layer, as a polycrystalline film, and represented by a composition formula of (K₁₋ₓNaₓ)NbO₃ (0 < x < 1),
wherein a crystal grain group forming the piezoelectric film includes a crystal grain having a ratio (=B/A ratio) of 0.01 nm⁻¹ or more and 0.1 nm⁻¹ or less, which is the ratio of an outer peripheral length B (nm) to a cross-sectional area A (nm²) when observing a cross-section of the crystal grain.

### (Supplementary description 2)

Preferably, there is provided the piezoelectric laminate of the supplementary description 1, wherein an average value of the ratio of the crystal grain group forming the piezoelectric film is 0.01 nm⁻¹ or more and 0.1 nm⁻¹ or less.

### (Supplementary description 3)

Preferably, there is provided the piezoelectric laminate of the supplementary description 1 or 2, wherein 60 % or more, and preferably 80 % or more crystal grains included in the crystal grain group forming the piezoelectric film have the ratio of 0.01 nm⁻¹ or more and 0.1 nm⁻¹ or less.

### (Supplementary description 4)

Preferably, there is provided the piezoelectric laminate of any one of the supplementary descriptions 1 to 3, wherein an average crystal grain size in the piezoelectric film is 100 nm or more.

### (Supplementary description 5)

Preferably, there is provided the piezoelectric laminate of any one of the supplementary descriptions 1 to 4, wherein when a positive or a negative electric field of 300 kV/cm is applied to an electrode film provided on the piezoelectric film at a temperature of 200 °C, the time from a start of applying the electric field until a leakage current density exceeds 30 mA/cm² is 18000 seconds or more, the electric field being at least one of the above electric fields applied under the above conditions, and the leakage current being flowed through the piezoelectric film.

### (Supplementary description 6)

Preferably, there is provided the piezoelectric laminate of any one of the supplementary descriptions 1 to 5, wherein the base layer functions as an electrode film (a bottom electrode film).

### (Supplementary description 7)

Preferably, there is provided the piezoelectric laminate of any one of the supplementary descriptions 1 to 6, wherein the piezoelectric film contains a metallic element selected from a group consisting of Cu and Mn at a concentration of 0.2 at% or more and 2.0 at% or less.

### (Supplementary description 8)

According to another aspect of the present disclosure, there is provided a piezoelectric element or a piezoelectric device, including:
a substrate;
a bottom electrode film formed on the substrate;
a piezoelectric film containing alkali niobium oxide and having a perovskite structure, which is formed on the bottom electrode film as a polycrystalline film, and represented by a composition formula of (K₁₋ₓNaₓ)NbO₃ (0 < x < 1); and
a top electrode film formed on the piezoelectric film,
wherein a crystal grain group forming the piezoelectric film includes a crystal grain having a ratio (=B/A ratio) of 0.01 nm⁻¹ or more and 0.1 nm⁻¹ or less, which is the ratio of an outer peripheral length B to a cross-sectional area A when observing a cross-section of the crystal grain.

### (Supplementary description 9)

According to further another aspect of the present disclosure, there is provided a piezoelectric element or a piezoelectric device, including:
a substrate;
a base layer formed on the substrate;
a piezoelectric film containing alkali niobium oxide and having a perovskite structure, which is formed on the base layer, as a polycrystalline film, and represented by a composition formula of (K₁₋ₓNaₓ)NbO₃ (0 < x < 1); and
an electrode film formed on the piezoelectric film,
wherein a crystal grain group forming the piezoelectric film includes a crystal grain having a ratio (=B/A ratio) of 0.01 nm⁻¹ or more and 0.1 nm⁻¹ or less, which is the ratio of an outer peripheral length B to a cross-sectional area A when observing a cross-section of the crystal grain.

### (Supplementary description 10)

According to further another aspect of the present disclosure, there is provided a method of manufacturing a piezoelectric laminate, piezoelectric element, or a piezoelectric device for forming a piezoelectric film including a crystal grain having a ratio (=B/A ratio) of 0.01 nm⁻¹ or more and 0.1 nm⁻¹ or less, which is the ratio of an outer peripheral length B (nm) to a cross-sectional area A (nm²) when observing a cross-section of the crystal grain forming the piezoelectric film, by sequentially performing:
forming a base layer on a substrate under a temperature condition of 600 °C or more; and
forming the piezoelectric film containing alkali niobium oxide and having a perovskite structure, which is formed on the base layer, as a polycrystalline film, and represented by a composition formula of (K₁₋ₓNaₓ)NbO₃ (0 < x < 1).

### DESCRIPTION OF SIGNS AND NUMERALS

- 1: Substrate
- 3: Piezoelectric film
- 10: Piezoelectric laminate

## Claims

1. A piezoelectric laminate, comprising:
a substrate;
a base layer formed on the substrate; and
a piezoelectric film containing alkali niobium oxide and having a perovskite structure, which is formed on the base layer, as a polycrystalline film, and represented by a composition formula of (K₁₋ₓNaₓ)NbO₃ (0 < x < 1),
wherein a crystal grain group forming the piezoelectric film includes a crystal grain having a ratio of 0.01 nm⁻¹ or more and 0.1 nm⁻¹ or less, which is the ratio of an outer peripheral length to a cross-sectional area when observing a cross-section of the crystal grain.

2. The piezoelectric laminate according to claim 1, wherein an average value of the ratio of the crystal grain group forming the piezoelectric film is 0.01 nm⁻¹ or more and 0.1 nm⁻¹ or less.

3. The piezoelectric laminate according to claim 1 or 2, wherein 60 % or more crystal grains included in the crystal grain group forming the piezoelectric film have the above ratio.

4. The piezoelectric laminate according to any one of claims 1 to 3, wherein an average crystal grain size in the piezoelectric film is 100 nm or more.

5. The piezoelectric laminate according to any one of claims 1 to 4, wherein the piezoelectric film contains a metallic element selected from a group consisting of Cu and Mn at a concentration of 0.2 at% or more and 2.0 at% or less.

6. A piezoelectric element, comprising:
a substrate;
a bottom electrode film formed on the substrate;
a piezoelectric film containing alkali niobium oxide and having a perovskite structure, which is formed on the bottom electrode film, as a polycrystalline film, and represented by a composition formula of (K₁₋ₓNaₓ)NbO₃ (0 < x < 1); and
a top electrode film formed on the piezoelectric film,
wherein a crystal grain group forming the piezoelectric film includes a crystal grain having a ratio of 0.01 nm⁻¹ or more and 0.1 nm⁻¹ or less, which is the ratio of an outer peripheral length to a cross-sectional area when observing a cross-section of the crystal grain.

7. A method of manufacturing a piezoelectric element for forming a piezoelectric film comprising a crystal grain having a ratio of 0.01 nm⁻¹ or more and 0.1 nm⁻¹ or less, which is the ratio of an outer peripheral length to a cross-sectional area when observing a cross-section of the crystal grain forming the piezoelectric film, by sequentially performing:
forming a base layer on a substrate under a temperature condition of 600 °C or more; and
forming the piezoelectric film containing alkali niobium oxide and having a perovskite structure, which is formed on the base layer, as a polycrystalline film, and represented by a composition formula of (K₁₋ₓNaₓ)NbO₃ (0 < x < 1).
